# EUROPÄISCHE PATENTSCHRIFT

(11) **EP 3 918 641 B1**
(45) Veröffentlichungstag und Bekanntmachung des Hinweises auf die Patenterteilung: **17.01.2024**
(21) Anmeldenummer: 20703018.0
(22) Anmeldetag: 31.01.2020
(51) Int. Cl.: H01L 31/048, H01J 9/26, H10K 50/84

(54) **EINRICHTUNG UND VERFAHREN ZUR HERSTELLUNG EINER PLATTENANORDNUNG**
SYSTEM AND METHOD FOR PRODUCING A PLATE ASSEMBLY
SYSTÈME ET PROCÉDÉ DE FABRICATION D'UN ENSEMBLE DE PLAQUES

(30) Priorität: 31.01.2019 DE 102019201274
(43) Veröffentlichungstag der Anmeldung: 08.12.2021
(73) Patentinhaber: Fraunhofer-Gesellschaft zur Förderung der angewandten Forschung e.V., 80686 München (DE)
(72) Erfinder: GREMMELSPACHER, Matthias, 79106 Freiburg (DE); KÜBLER, Dr. Rainer, 79106 Freiburg (DE); RIST, Tobias, 79194 Grundelfingen (DE); KOTT, Alexander, 79110 Freiburg (DE); HOLLER, Philipp, 77966 Kappel-Grafenhausen (DE)
(74) Vertreter: Pfenning, Meinig & Partner mbB
(86) Internationale Anmeldenummer: PCT/EP2020/052404
(87) Internationale Veröffentlichungsnummer: WO 2020/157266

(56) Entgegenhaltungen:
- US-A- 4 139 250
- US-A1- 2006 001 373
- US-B1- 6 840 833

## Beschreibung

Die Erfindung liegt auf dem Gebiet der Verfahrenstechnik, des Maschinenbaus und der Elektronik und ist mit besonderem Vorteil bei der Herstellung von elektrischen Komponenten anwendbar.

Bei der Herstellung einiger elektronischer Komponenten, wie beispielsweise von Panels für die Photovoltaik oder elektronischer Anzeigenkomponenten für Bildschirme, ist es notwendig, sehr flache Bauteile oder Schichten von funktionalen Medien fluiddicht zu versiegeln und damit vor dem Zutritt von Feuchtigkeit oder Sauerstoff dauerhaft zu schützen. Die entsprechenden Medien, die beispielsweise als Fluid oder dünnschichtiger Festkörper vorliegen können, sollen dabei Schichtdicken in der Größenordnung von einigen zehn Mikrometern aufweisen, wobei eine besondere Anforderung darin liegt, dass die Schichtdicke über die Fläche möglichst konstant sein soll und nur Schichtdickenunterschiede von beispielsweise wenigen Mikrometern aufweisen soll. Derart geringe und gut definierte Schichtdicken sind beispielsweise für die Herstellung von Perowskit-Solarzellen notwendig.

Üblicherweise findet eine Versiegelung im Zwischenraum zwischen zwei Platten statt, wobei der Zwischenraum umlaufend, beispielsweise durch ein Lot, abgedichtet werden kann. In vielen Fällen werden Platten aus Glas eingesetzt, jedoch ist auch die Verwendung anderer Werkstoffe, insbesondere im optischen Wellenlängenbereich transparenter Werkstoffe, möglich. Außer der Abdichtung am Umfang der Platten können auch fluiddichte und/oder degradationshemmende Unterteilungen des Zwischenraums zwischen den Platten mittels eines Lots vorgesehen sein.

Gemäß dem Stand der Technik werden üblicherweise Glasplatten verwendet, die im Floatglasverfahren hergestellt werden. Prozessbedingt haben solche Floatglasscheiben eine Welligkeit im Bereich von einigen Zehntelmillimetern. Eine Gleichmäßigkeit des Zwischenraums zwischen solchen Floatglasscheiben wird bisher dadurch erreicht, dass als Dichtmittel ein Glaslot verwendet wird und dass zur Abdichtung des Zwischenraums zwischen den Glasplatten eine Temperatur eingestellt wird, bei der einerseits das Glaslot schmilzt und andererseits die Glasplatten erweichen, so dass sich durch Wirkung der Gravitationskraft die jeweils obere Scheibe auf der unteren Scheibe ablegt, wodurch ein geringer, in akzeptabler Weise definierter Spalt entsteht.

Ein Nachteil des bekannten Verfahrens liegt darin, dass nach der anfänglichen Verformung der oberen Glasplatte und dem teilweisen Ablegen auf der unteren Glasplatte die lokal wirkenden Gewichtskräfte, die für das weitere Anschmiegen von übrigen Teilen der oberen Platte an die untere Platte sorgen müssen, sich stetig verringern, so dass bei vertretbaren Temperaturen die Prozessdauer relativ hoch ist. Die Gleichmäßigkeit des Zwischenraums, die sich durch die bekannten Verfahren erreichen lässt, ist für viele Anwendungen nicht ausreichend. Besonders die Herstellung sehr enger und gleichmäßiger Spalte mit einer Dicke des Zwischenraums von weniger als 100 Mikrometern ist bei diesen Anforderungen schwierig. US 6 840 833 B1 offenbart ein Verfahren zur Herstellung einer Plattenanordnung mit zwei Platten, wobei zwischen den Platten ein schmelzbarer Lotwerkstoff angeordnet ist.

Der vorliegenden Erfindung liegt vor dem Hintergrund des genannten Standes der Technik die Aufgabe zugrunde, ein Verfahren zur Herstellung einer Plattenanordnung zu schaffen, das die Herstellung von Zwischenräumen geringer Dicke bei sehr hoher Konstanz der Maße über die Fläche erlaubt.

Die Aufgabe wird gemäß der Erfindung durch ein Verfahren mit den Merkmalen des Patentanspruchs 1 gelöst. Die Patentansprüche 2 bis 4 und 6 bis 8 stellen besondere Implementierungen des Verfahrens vor. Die Erfindung bezieht sich zudem auf eine Einrichtung zur Herstellung einer Plattenanordnung gemäß Patentanspruch 5.

Die Erfindung bezieht sich demnach auf ein Verfahren zur Herstellung einer Plattenanordnung mit zwei Platten, die wenigstens abschnittsweise einen zwischen ihnen gelegenen Zwischenraum und einen gleichbleibenden Abstand zueinander aufweisen und/oder parallel zueinander angeordnet sind und zwischen denen ein schmelzbarer Lotwerkstoff angeordnet ist. Die Aufgabe wird dabei dadurch gelöst, dass eine Druckdifferenz zwischen dem Zwischenraum zwischen den Platten und dem die Platten umgebenden Außenraum erzeugt wird, derart, dass der Druck im Außenraum höher ist als im Zwischenraum und dass die Temperatur des Lotwerkstoffes zumindest zeitweise während des Bestehens der Druckdifferenz vorübergehend über seine Schmelztemperatur oder Verarbeitungstemperatur erhöht wird.

Durch die Erzeugung eines Druckunterschieds können große Kräfte erzeugt werden, die zu einer Verringerung des Zwischenraums zwischen den Platten führen können. Die Kräfte können durch die Bemessung des Druckunterschieds gesteuert werden. Die durch den Außendruck auf die Platten erzeugte Kompressionskraft kann sich bei einer horizontalen Lagerung der Platten zur Gewichtskraft, die auf die obere der Platten wirkt, hinzuaddieren. Wenn im Zwischenraum Unterdruck eingebracht wird, wobei der Unterdruck insbesondere einen Wert von 10 bis 900 mbar betragen kann, kann der Druckunterschied, bedingt durch den äußeren Luftdruck, zwischen 0 und 1 bar, insbesondere zwischen 10 bis 900 mbar, betragen. Wenn zusätzlich oder alleine äußerer Gas-Druck aufgebracht wird, kann der Druckunterschied bis zu 10 bar betragen. In dem Fall wird zur Anwendung des beschriebenen Verfahrens eine Art Überdruckkammer benötigt.

Durch Aufbringen eines Druckunterschieds wird der Zeitraum, der bis zum Erreichen der angestrebten Verformung der Platten benötigt wird reduziert, gegenüber Verfahren bei denen ausschließlich die Schwerkraft die Annäherung der beiden Platte bewirkt. Der Druckunterschied kann beispielsweise für eine Dauer von mindestens einer Sekunde und/oder von höchstens 120 Sekunden, vorzugsweise von höchstens 30 Sekunden aufgebracht werden. Mit dem Unterdruck kann dabei eine flächige Kraft aufgebracht werden, um einen definierten Spalt zwischen den Platten zu erhalten. Der Spaltabstand kann beispielsweise von dem aus dem angelegten Unterdruck resultierenden Flächendruck, der temperaturabhängigen Viskosität des Fügemittels und der Dauer der Krafteinwirkung abhängen. Eine Steuerung der Höhe sowie des zeitlichen Verlaufs des angelegten Druckunterschieds sollte mit Bedacht und fein dosiert erfolgen, denn ein zu hoher Druckunterschied und/oder ein zu lang angelegter Druck können die Platten unerwünscht stark aneinander quetschen und einen viel zu geringen Spalt zwischen den Platten erzeugen. Nach Erreichen des finalen Abstands zwischen den Platten kann der Unterdruck wieder aufgehoben werden, damit der Zwischenraum mit funktionalen Medien, wie beispielsweise einem Gas oder einer Flüssigkeit, gefüllt werden kann. In vielen Fällen hängt der final erreichte Abstand zwischen den Platten, der beispielsweise höchstens 100 µm betragen kann, von der Viskosität des Lotwerkstoffs und seiner Oberflächenenergie ab, sofern die zur Verfügung stehenden und auf die Platten wirkenden Kompressionskräfte nicht zu groß sind. Oft findet die Annäherung der Platten wegen der Viskosität des Lotwerkstoffs nur sehr langsam statt, so dass der Abstand zwischen den Platten zeitabhängig wird. Diese Zeitabhängigkeit kann durch Einwirkung einer ausreichend großen Kompressionskraft durch den erzeugten Druckunterschied eliminiert werden.

Die Erfindung sieht vor, dass wenigstens eine Platte, insbesondere beide Platten, während der Zeit, in der der Druck im Außenraum, d. h. außerhalb des Zwischenraums zwischen den Platten, höher ist als im Zwischenraum, zumindest vorübergehend bis über die Erweichungstemperatur ihres Materials hinaus erhitzt werden. In diesem Fall sind die Platten plastisch verformbar, solange die Temperatur oberhalb der Erweichungstemperatur des Materials der Platten eingestellt wird. Zusätzlich oder alternativ kann eine Platte mit einer geringeren Dicke verwendet werden, um eine elastisch Verformung der Platte zu bezwecken. Die Dicke des Zwischenraums wird im Wesentlichen durch die Dicke des zwischen den Platten eingebrachten Lotwerkstoffs bestimmt. Wird der Lotwerkstoff ausreichend verflüssigt und ihm genügend Zeit gegeben, sich zwischen den Platten zu verteilen, so lässt sich der Abstand zwischen den Platten bis auf nahezu null, insbesondere wenigstens bereichsweise auf nahezu null, vorzugsweise auf 5 bis 100 µm, besonders bevorzugt auf 5 bis 50 µm, einstellen. Dabei bestimmen die Parameter Temperatur, temperaturabhängige Viskosität des Materials der Platten (z. B. Glas) und des Lots sowie Druckdifferenz zwischen dem Zwischenraum der Platten und dem Außenraum den zeitlichen Verlauf der Verringerung des Spalts/Zwischenraums zwischen den Platten. Dabei können die Platten eben oder auch gekrümmt sein. Sind sie gekrümmt, so ist der Zwischenraum als durch gekrümmte Flächen begrenztes Volumen ausgebildet, wobei die Dicke jeweils senkrecht zu den Begrenzungsflächen - also den Oberflächen der Platten - gemessen wird.

In einer weiteren Ausgestaltung kann beispielsweise vorgesehen sein, dass zwischen den Platten, insbesondere in dem Lotwerkstoff, Partikel angeordnet werden, deren Durchmesser dem zu erzielenden Abstand zwischen den Platten entspricht und deren Erweichungstemperatur höher liegt als die Schmelztemperatur des Lotwerkstoffs, wobei die Temperatur während der Verbindung der Platten unterhalb der Erweichungstemperatur des Partikelmaterials bleibt. In diesem Fall kann der Abstand zwischen den Platten und damit die Dicke des Zwischenraums zwischen den Platten bis auf das Maß der zwischen den Platten angeordneten Partikel reduziert werden. Die Partikel können beispielsweise als Menge von Glaskugeln von möglichst gleichmäßigem Durchmesser realisiert sein. Der Durchmesser der Partikel kann beispielsweise zwischen 5 bis 50 µm betragen.

Eine weitere Ausgestaltung der Erfindung kann vorsehen, dass die Partikel in dem Zwischenraum entlang zu erzeugender Kanäle angeordnet werden. In diesem Fall können sich, wenn die Partikel beispielsweise entlang von Linien parallel zu den gewünschten Kanälen aneinandergereiht werden, in unmittelbarer Nachbarschaft der Partikel zwickelförmige Räume als Kanäle ausbilden, die zur Befüllung des Zwischenraums zwischen den Platten mit einem funktionalen Medium, beispielsweise einem Gas oder einer Flüssigkeit, dienen können. Der Durchmesser der Partikel kann bei dieser Ausgestaltung beispielsweise zwischen 50 bis 500 µm betragen, bevorzugt zwischen 100 bis 200µm.

Die Druckdifferenz zwischen dem Zwischenraum, der durch die beiden Platten begrenzt wird und deren Außenraum kann dadurch erzeugt werden, dass bei einer gegebenen Füllung und Abdichtung des Zwischenraums ein erhöhter Außendruck erzeugt wird. Eine andere Alternative, die üblicherweise einfacher zu realisieren ist, kann darin bestehen, dass bei gegebenem Außendruck Gas aus dem Volumen des Zwischenraums zwischen den Platten abgesaugt wird, so dass dort ein Unterdruck entsteht. In diesem Fall bewirkt der Atmosphärendruck, der von außen auf die Platten wirkt, die Erzeugung eines Überdrucks. Dieser kann zusätzlich noch durch Vergrößerung des Außendrucks in einer Druckkammer erhöht werden.

Es kann dabei zudem gemäß der Erfindung vorgesehen sein, dass während des Verbindungsvorgangs der Platten die Druckdifferenz zwischen dem Innenraum und dem Außenraum der Platten mittels einer Druckmesseinrichtung gemessen wird. Damit kann sichergestellt werden, dass die Druckdifferenz ausreicht, um bei den gegebenen Temperaturen und den hieraus folgenden Viskositäten der beteiligten Werkstoffe in einer bestimmbaren und begrenzten Zeit die Verformung der beteiligten Materialien, also des Lotwerkstoffs und des Plattenwerkstoffs, in dem gewünschten Maß herbeizuführen.

Zudem kann vorgesehen sein, dass während des Verbindungsvorgangs der Platten mittels eines Temperatursensors die Temperatur gemessen wird. Dabei kann beispielsweise auch der Abstand zwischen den Platten an verschiedenen Punkten laufend gemessen werden, so dass über eine Temperatursteuerung eine Überwachung und Regelung des Setzvorgangs einer oder beider der Platten gewährleistet werden kann.

Die Erfindung bezieht sich außer auf ein Verfahren der oben erläuterten Art auch auf eine Einrichtung zur Herstellung einer Plattenanordnung mit zwei Platten, die wenigstens abschnittsweise einen gleichbleibenden Abstand zueinander aufweisen und/oder parallel zu einander angeordnet sind, wobei die Einrichtung eine Vakuumvorrichtung zum Absaugen eines Fluids, insbesondere eines Gases, aus dem Zwischenraum zwischen dem Platten aufweist.

Eine solche Einrichtung kann beispielsweise auch eine Überdruckkammer vorsehen, in die die Plattenanordnung gebracht wird. Die Erzeugung eines Unterdrucks im Zwischenraum zwischen den Platten kann jedoch bereits zur Erzeugung der notwendigen Kräfte ausreichen, und die Einrichtung zur Erzeugung eines Druckunterschieds kann im Rahmen einer Vakuumvorrichtung eine Absaugpumpe sowie Absaugschläuche, Ventile und Saugstutzen vorsehen, die an wenigstens eine der Platten zum Absaugen eines Fluids im Bereich einer Öffnung, beispielsweise einer Bohrung in einer Platte, ansetzbar sind. Die Absaugstutzen können beispielsweise an einer Platte mittels einer Abdichtvorrichtung, beispielsweise einer Elastomerdichtung, abgedichtet sein.

Die Platten können beispielsweise im Zuge des Herstellungsverfahrens auf einem Unterdruckträger gelagert sein, wobei der Unterdruckträger fluiddicht mit den Platten verbunden bleibt, so dass die Platten problemlos mit dem Unterdruckträger gehandhabt werden können. Der Unterdruckträger kann nach Erzeugung eines Unterdrucks auch von einer Absaugpumpe getrennt und abgedichtet werden.

Zudem kann bei einer genannten Einrichtung zur Herstellung einer Plattenanordnung vorgesehen sein, dass sie eine Vorrichtung zur Steuerung der Temperatur der Plattenanordnung mittels einer Heizung aufweist. Da bei einigen Varianten des erläuterten Verfahrens der erzielte Zwischenraum und seine Maße von der eingestellten Temperatur und der Zeitdauer der Temperatureinwirkung abhängig sein können, ist für einige Varianten des erfindungsgemäßen Verfahrens eine Temperatursteuerung auch zeitabhängig hilfreich oder notwendig.

Ferner kann die oben genannte Einrichtung eine Vorrichtung zur Aufhebung einer Druckdifferenz zwischen dem Zwischenraum 4 der Platten 1, 2 und zur Befüllung des Zwischenraumes 4 der Platten 1, 2 mit einem funktionalen Medium aufweisen. Die Vorrichtung kann beispielsweise eine Pumpe sein. Das funktionale Medium kann beispielsweise ein Gas oder eine Flüssigkeit sein.

Im Folgenden wird die Erfindung anhand von Ausführungsbeispielen in Figuren einer Zeichnung gezeigt und nachfolgend erläutert. Dabei zeigt
- Fig. 1: zwei Platten in einem Querschnitt vor dem Zusammenfügen,
- Fig. 2: zwei Platten im Querschnitt nach dem Zusammenfügen,
- Fig. 3: zwei weitere Platten im Querschnitt vor dem Zusammenfügen,
- Fig. 4: die Platten aus Figur 3 nach dem Zusammenfügen,
- Fig. 5: zwei weitere Platten im Querschnitt vor dem Zusammenfügen mit abstandhaltenden Partikeln,
- Fig. 6: die beiden Platten aus Figur 5 nach dem Zusammenfügen mit den abstandhaltenden Partikeln,
- Fig. 7: zwei Platten nach dem Zusammenfügen mit abstandhaltenden Partikeln, die Fließkanäle erzeugen,
- Fig. 8: im Querschnitt zwei Platten vor dem Zusammenfügen gemeinsam mit einer Vorrichtung zur Vakuumerzeugung sowie
- Fig. 9: ein Diagramm, in dem der zeitliche Temperaturverlauf beispielhaft während des Fügeverfahrens dargestellt ist.

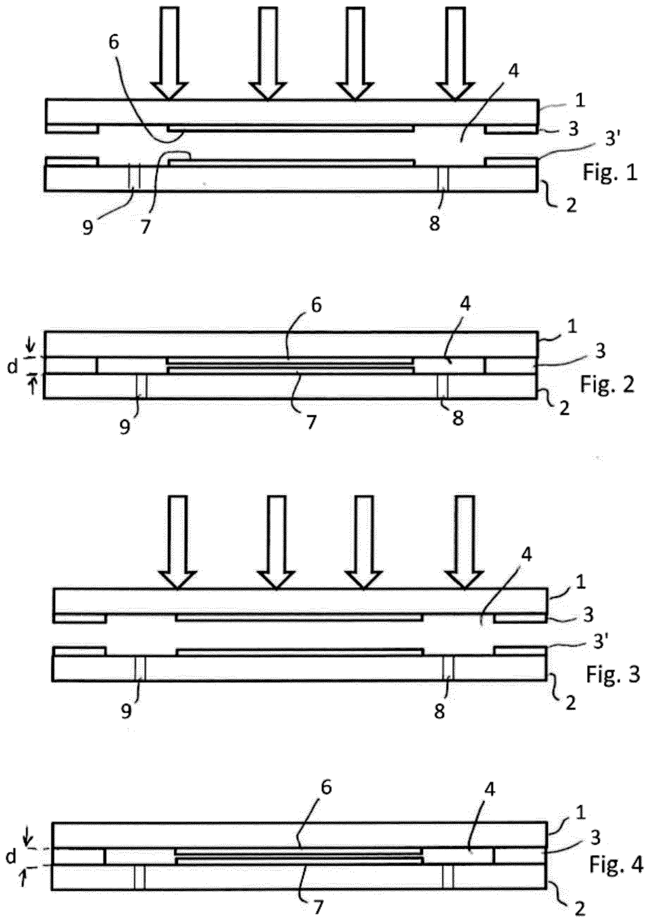

Figur 1 zeigt im Querschnitt eine erste Platte 1, die parallel zu einer zweiten Platte 2 im Abstand von dieser angeordnet ist. Wenigstens eine Platte oder beide Platten können aus einem optisch transparenten Medium, insbesondere aus Glas, bestehen und im Floatglasverfahren oder einem anderen geeigneten Verfahren in ebener, flacher Form hergestellt sein. Wenigstens eine der Platten, insbesondere jedoch, wie in Figur 1 dargestellt, beide Platten, kann mit einer Funktionsschicht oder mit einem Funktionswerkstoff 6, 7 an der der anderen Platte zugewandten Oberfläche wenigstens teilweise oder abschnittsweise bedeckt sein. Dabei können die Funktionsschichten als feste Schicht, als Gelschicht oder als Flüssigkeitsschicht vorliegen.

Das Ziel des erfindungsgemäßen Verfahrens ist es, die beiden Platten 1, 2 in einen definierten und möglichst über weite Abschnitte an allen Stellen gleichen Abstand zueinander zu bringen. Ideal ist dabei ein Abstand d zwischen den Platten 1, 2, der in der Größenordnung zwischen einigen Mikrometern und einigen zehn Mikrometern liegt und der über die Fläche, über die die beiden Platten 1, 2 parallel zueinander verlaufen, möglichst in geringem Maße, idealerweise um weniger als 5 µm, variiert.

Wenigstens eine der Platten 1, 2 oder beide Platten sind an der der anderen Platte zugewandten Fläche mit einem Lotwerkstoff 3, 3' bedeckt. Dabei können die jeweils mit dem Lotwerkstoff bedeckten Teilflächen der beiden Platten 1, 2 einander direkt gegenüberliegen oder auch gegeneinander verschoben sein.

In Figur 1 ist an der unteren, zweiten Platte 2 dargestellt, dass diese zwei Absaugöffnungen 8, 9 in Form von Bohrungen aufweist, durch die ein Fluid, insbesondere Gas, abgesaugt werden kann. Die Pfeile deuten an, dass auf die obere, erste Platte ein Gasdruck, beispielsweise der atmosphärische Luftdruck, wirkt. Werden die beiden Platten 1, 2 aufeinandergelegt, so kann begonnen werden, Gas, insbesondere Luft, durch die Absaugöffnungen 8, 9 abzusaugen. Sind die Platten 1, 2 wenigstens teilweise an ihrem Umfang abgedichtet, beispielsweise dadurch, dass die Beschichtungen aus einem Lotwerkstoff 3, 3' aufeinander aufliegen, und spätestens dann, wenn der Lotwerkstoff schmilzt, kann der Druck im Zwischenraum 4 zwischen den Platten 1, 2 abgesenkt werden. Teilweise durch die auf die erste Platte 1 wirkende Gewichtskraft und unterstützt durch den Atmosphärendruck oder einen anderweitig erzeugten Überdruck können die Platten 1, 2 weiter zusammengedrückt werden, wobei die Abdichtung an ihrem Umfang verbessert wird und der Druck im Zwischenraum 4 weiter abgesenkt werden kann. Die Druckdifferenz zwischen Zwischenraum 4 und Atmosphärendruck kann zwischen 10 bis 900 mbar betragen. Ziel der erzeugten Druckdifferenz ist unter anderem das Aufbringen einer flächig homogenen Kraft, um eine möglichst homogene Spaltdicke zu erreichen.

Üblicherweise wird die Temperatur der Platten 1, 2 und des Lotwerkstoffs 3, 3' bereits vor der Anwendung einer Absaugvorrichtung erhöht. Die Temperatur wird einerseits über die Schmelztemperatur des Lotwerkstoffs 3, 3' und andererseits auch über die Erweichungstemperatur des Werkstoffs der Platten 1, 2, also beispielsweise die Erweichungstemperatur des verwendeten Glases, erhöht. Steigt die Temperatur beim Aufheizen über die Schmelztemperatur des Lotwerkstoffs 3, 3', so wird durch die Fließfähigkeit des Lotwerkstoffs das Abdichten des Zwischenraums 4 zwischen den Platten 1, 2 bewirkt, der Druck im Zwischenraum 4 kann sinken, und die auf die Platte 1 wirkende Kraft durch den wirkenden Druckunterschied kann weiter ansteigen.

Die Temperatur wird über die Erweichungstemperatur des Materials, beispielsweise des Glases, aus dem die Platten 1, 2 bestehen, angehoben. Dadurch werden die Platten 1, 2 plastisch verformbar, und die Platte 1 senkt sich so weit auf die Platte 2 ab, dass der Abstand zwischen den Platten 1, 2 oder zwischen den Funktionsmedien 6, 7 oder zwischen einer Platte und einem auf der gegenüberliegenden Platte angeordneten Funktionsmedium auf wenige Mikrometer verringert wird. Die Funktionsmedien 6, 7 können sich an einigen Stellen berühren, um so den Abstand von wenigen Mikrometern einzustellen.

Wird die Temperatur nach dem Zusammenfügen wieder abgesenkt, so erstarren die Platten 1, 2, und der Abstand bleibt auch nach der Beseitigung des Druckunterschieds zwischen dem Zwischenraum 4 und dem Außenraum erhalten, insbesondere nach Anlegen eines Drucks von etwa 1000 mbar im Zwischenraum 4. Dieser Zustand ist in Figur 2 dargestellt. Der Druckunterschied kann beispielsweise für eine Dauer zwischen 1 und 120 Sekunden angelegt sein. Der Abstand zwischen den Platten 1, 2 ist mit d bezeichnet und kann beispielsweise höchstens 100 µm betragen.

In Figur 3 ist dieselbe Ausgangssituation dargestellt wie in Figur 1. Die Platten 1, 2 werden durch das Eigengewicht der Platte 1 sowie einen Druckunterschied beim Absaugen von Gas durch die Öffnungen 8, 9 gegeneinandergedrückt. Im Unterschied zu dem anhand der Figuren 1 und 2 beschriebenen Verfahren werden hier ein Lotwerkstoff und ein Material für die Platten 1, 2 verwendet, die so beschaffen sind, dass die Schmelztemperatur des Lotwerkstoffs 3, 3' unterhalb der Erweichungstemperatur des Materials/Glases ist, aus dem die Platten 1, 2 bestehen. Besteht eine der Platten 1, 2 beispielsweise aus einem Einscheiben-Sicherheitsglas, dessen mechanische Eigenschaften eine Aufheizung über mehr als 350 °C nicht zulassen, so darf dieser Temperaturwert nicht überschritten werden, und der Schmelzpunkt des Lotwerkstoffs muss unter dieser Temperatur liegen.

Ausgehend von dem in Figur 3 dargestellten Zustand werden die Platten 1, 2 aufeinandergelegt, und durch die Erzeugung von Unterdruck im Zwischenraum 4 werden die Platten 1, 2 aneinandergedrückt. Gleichzeitig wird der Lotwerkstoff 3, 3' verflüssigt und verbindet sich mit beiden Platten 1, 2, wie in Figur 4 dargestellt ist. Ist der Lotwerkstoff 3, 3' viskos, so kann die Temperatursteuerung so betrieben werden, dass die Zeit, über die der Lotwerkstoff verflüssigt ist, ausreicht, um den Lotwerkstoff zwischen den Platten 1, 2 ausreichend zu verteilen, so dass der gewünschte Abstand d zwischen den Platten 1, 2 bzw. der gewünschte Abstand zwischen den Funktionsmedien 6, 7 eingestellt ist. Danach wird die Temperatur abgesenkt, so dass der Lotwerkstoff erstarrt und die Platten 1, 2, die bei Wegfallen des Druckunterschieds wieder elastisch voneinander wegstreben, hält. Der Abstand zwischen den Platten 1, 2 bleibt danach im Wesentlichen konstant, da diese durch den Lotwerkstoff auch nach Wegfall des Druckunterschieds gehalten werden.

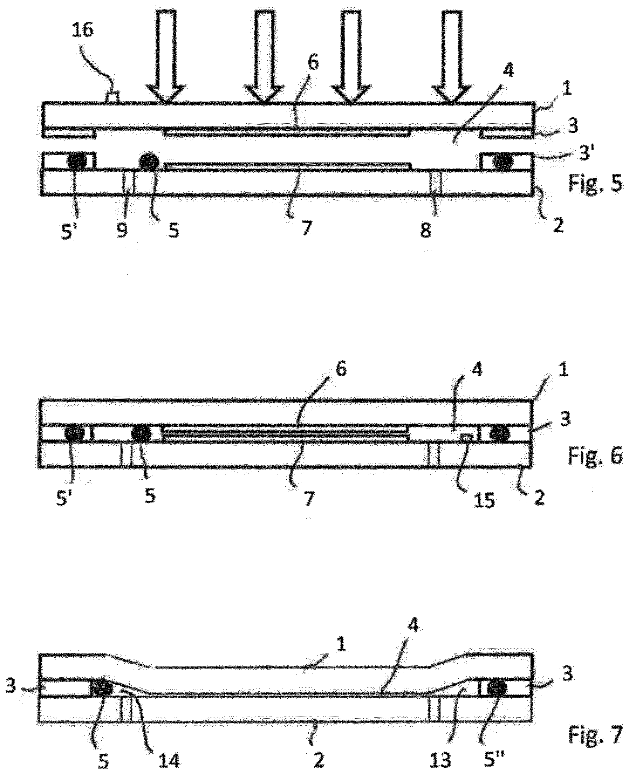

In Figur 5 ist ein Ausgangszustand mit zwei Platten 1, 2 dargestellt, zwischen denen Partikel 5, 5', beispielsweise in Form von Glaskugeln, angeordnet sind. Beispielhaft ist das Partikel 5 als freies Partikel zwischen den Platten 1, 2 dargestellt, während das Partikel 5' in den Lotwerkstoff 3' integriert ist.

Wie bereits oben erläutert, wird zwischen den Platten 1, 2 ein Druckunterschied bei gleichzeitiger Temperaturerhöhung erzeugt. Dabei kann in einem Fall der Lotwerkstoff und das Material der Platten 1, 2 derart aufeinander abgestimmt sein, dass zum Schmelzen des Lotwerkstoffs die Erweichungstemperatur des Materials der Platten 1, 2 nicht erreicht wird, oder die Materialien können auch so gewählt werden, dass die Schmelztemperatur des Lotwerkstoffs 3, 3' etwa bei der Erweichungstemperatur des Materials der Platten oder oberhalb dieser Erweichungstemperatur liegt. Daher können beim Herstellen der Plattenanordnung grundsätzlich sowohl die anhand der Figuren 1 und 2 dargestellten Vorgänge ablaufen als auch die anhand der Figuren 3 und 4 dargestellten Vorgänge.

In jedem Fall wird der Abstand d zwischen den Platten 1, 2 nicht geringer als der Durchmesser oder die äußeren Abmessungen der Partikel 5, 5'. Der Durchmesser der Partikel 5, 5' beträgt beispielsweise 5 bis 50 µm. Die Partikel 5, 5' wirken somit als Abstandhalter und stellen den minimalen Abstand d ein. Dies geschieht sowohl bei der Erweichung der Platten 1, 2 als auch bei der Variante des Verfahrens, bei der die Platten 1, 2 nicht erweicht werden. Damit kann mittels der abstandhaltenden Partikel 5, 5' der Wunschabstand von beispielsweise 5 bis 50 µm zwischen den Platten 1, 2 oder zwischen den Funktionsmedien 6, 7 eingestellt werden.

Anhand der Figur 7 ist dargestellt, dass bei einer ausreichenden Aufheizung der Platten über ihre Erweichungstemperatur diese sich dennoch so weit verformen können, dass sie sich in den Bereichen, in den keine abstandhaltenden Partikel angeordnet sind, einander auf einen Abstand nähern, der kleiner als die äußeren Abmaße der Partikel ist. In diesem Fall können die Partikel 5, 5" gezielt so angeordnet werden, dass sie in Reihen oder entlang gerader oder gekrümmter Linien positioniert sind. In der unmittelbaren Umgebung von Partikeln werden die Platten 1, 2 sich einander nicht so weit annähern können wie in den Bereichen, die fern den Partikeln 5, 5" liegen. Dies führt dazu, dass in unmittelbarer Nähe der Partikel Hohlräume gebildet werden. Sind die Partikel in einer Reihe oder Linie angeordnet, so verbinden sich die genannten Hohlräume zu Kanälen, die für einen Fluidtransport im Zwischenraum 4 zwischen den Platten 1, 2 zur Verfügung stehen und zu einem besseren Transport von Medien dienen können, die in den Zwischenraum transportiert oder aus diesem entfernt werden sollen. Dies ist beispielsweise dann besonders einfach möglich, wenn die Partikel 5" innerhalb eines Lotwerkstoffs angeordnet und durch diesen vor der Erweichung des Lotwerkstoffs an Ort und Stelle gehalten werden können. Die Partikel können jedoch auch vor dem Herstellungsprozess der Plattenanordnung auf einer der Platten durch Kleben oder in anderer Weise fixiert werden.

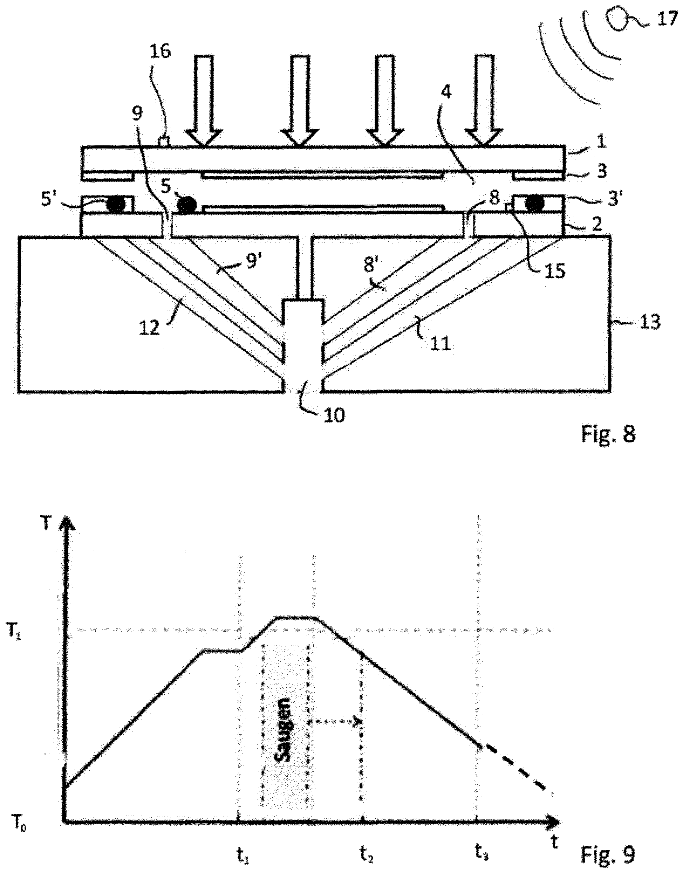

Figur 8 zeigt in einem Querschnitt eine Anordnung mit zwei Platten 1, 2 vor dem Zusammenfügen, wobei unterhalb der zweiten Platte 2 eine Vakuumvorrichtung zum Absaugen eines Fluids aus dem Zwischenraum 4 angeordnet ist. Die Vakuumvorrichtung weist eine Basisplatte 13 sowie eine nicht dargestellte Absaugpumpe auf. Innerhalb der Basisplatte 13 ist ein zentraler Absaugkanal 10 dargestellt. An diesen sind Absaugkanäle 8', 9' angeschlossen, die jeweils an Bohrungen 8, 9 der zweiten Platten münden, durch die aus dem Zwischenraum 4 ein Fluid abgesaugt werden kann.

Die zusätzlichen Kanäle 11, 12 enden an der unteren Platte 2 und erzeugen dort einen Unterdruck, der die Platte 2 an der Basisplatte 13 festhält. Damit kann die Plattenanordnung während der Durchführung des Verfahrens mittels der Basisplatte 13 leicht gehandhabt werden.

Nach Abdichten des Zwischenraums zwischen den Platten 1, 2 und Erzeugen eines Unterdrucks im Zwischenraum 4 kann der Kanal 10 verschlossen werden, so dass durch den bleibenden Unterdruck sowohl ein Unterdruck im Zwischenraum 4 erhalten bleibt als auch eine Anpresskraft der Plattenanordnung 1, 2 gegen die Basisplatte 13 erzeugt wird. In diesem Zustand kann dann die Temperaturbehandlung erfolgen. Im Anschluss an die Temperaturbehandlung kann der Kanal 10 geöffnet werden, um den Unterdruck in dem Zwischenraum 4 aufzuheben und einen atmosphärischen Normaldruck von etwa 1000 mbar in dem Zwischenraum 4 zu erhalten. Der Abstand zwischen den Platten bleibt dabei erhalten. Dies ermöglicht bzw. erleichtert eine anschließende Füllung des Zwischenraums 4 mit funktionalen Medien, wie beispielsweise einem Gas oder einer Flüssigkeit. Dies kann mittels einer Vorrichtung zur Aufhebung der Druckdifferenz zwischen dem Zwischenraum 4 der Platten 1, 2 und zur Befüllung des Zwischenraumes 4 der Platten 1, 2 mit einem funktionalen Medium (nicht dargestellt) erfolgen.

Figur 9 zeigt in einem Diagramm den Verlauf der Temperatur, der die Plattenanordnung 1, 2 über eine Zeit t unterworfen wird. Die Temperatur T wird zunächst über einen Anfangszeitraum bis zum Zeitpunkt t₁ von der Raumtemperatur T₀ ausgehend angehoben. Zu diesem Zeitpunkt etwa beginnt die Anwendung von Unterdruck durch das Absaugen von Fluid durch die Öffnungen 8, 9 in der Platte 2. Die Temperatur kann daraufhin noch geringfügig über die Temperatur T₁ hinaus erhöht werden. Die erhöhte Temperatur wird über eine bestimmte Zeit bis etwa zum Zeitpunkt t₂ gehalten und dann abgesenkt. Der Absaugvorgang kann bereits vor dem Zeitpunkt tz oder auch erst zum Zeitpunkt t₂ angehalten werden. Daraufhin wird die Temperatur bis zum Zeitpunkt t₃ langsam abgesenkt. Nach dem Zeitpunkt t₃ kann die Temperatur weiter bis auf Raumtemperatur abgesenkt werden.

Mit der Temperatur T₁ ist die Schmelztemperatur des Lotwerkstoffs 3, 3' bezeichnet. Da die Temperatur über diese Schmelztemperatur hinaus erhöht wird, hängt die Tatsache, ob die Platten erweicht werden, davon ab, ob deren Erweichungstemperatur oberhalb oder unterhalb der Schmelztemperatur des Lotwerkstoffs liegt und während des beschriebenen Verfahrens wenigstens zeitweise erreicht wird oder nicht.

Durch Wahl der verwendeten Materialien, mit abgestimmten Erweichungs- bzw. Verarbeitungstemperaturen, kann bei geeigneter Temperatursteuerung auch über die Zeit, d. h. bei der Einstellung eines zeitabhängigen Temperaturprofils, erreicht werden, dass durch Schmelzen des Lotwerkstoffs eine fluiddichte Verbindung der Platten 1, 2 miteinander geschaffen wird, wobei zudem der gewünschte Abstand zwischen den Platten oder zwischen den zwischen ihnen befindlichen Funktionsmedien genau und mit geringsten ortsabhängigen Abweichungen eingestellt werden kann.

## Patentansprüche

1. Verfahren zur Herstellung einer Plattenanordnung mit zwei Platten (1, 2), die wenigstens abschnittsweise einen zwischen ihnen gelegenen Zwischenraum (4) und einen gleichbleibenden Abstand (d) zueinander aufweisen und/oder parallel zueinander angeordnet sind und zwischen denen ein schmelzbarer Lotwerkstoff (3, 3') angeordnet ist, wobei eine Druckdifferenz zwischen dem Zwischenraum (4) zwischen den Platten und dem die Platten umgebenden Außenraum erzeugt wird, derart, dass der Druck im Außenraum höher ist als im Zwischenraum (4) und dass die Temperatur des Lotwerkstoffes (3, 3') zumindest zeitweise während des Bestehens der Druckdifferenz vorübergehend über seine Schmelztemperatur oder seine Verbindungstemperatur erhöht wird, **dadurch gekennzeichnet, dass** wenigstens eine Platte, insbesondere beide Platten (1, 2), während der Zeit, in der der Druck im Außenraum höher ist als im Zwischenraum (4), zumindest vorübergehend bis über die Erweichungstemperatur ihres Materials hinaus erhitzt werden.

2. Verfahren nach Anspruch 1, **dadurch gekennzeichnet, dass** zwischen den Platten (1, 2), insbesondere in dem Lotwerkstoff (3, 3'), Partikel (5, 5') angeordnet werden, deren Durchmesser dem zu erzielenden Abstand (d) zwischen den Platten entspricht und deren Erweichungstemperatur höher liegt als die Schmelztemperatur des Lotwerkstoffs (3, 3'), wobei die Temperatur während der Verbindung der Platten unterhalb der Erweichungstemperatur des Partikelmaterials bleibt.

3. Verfahren nach Anspruch 2, **dadurch gekennzeichnet, dass** die Partikel (5, 5') in dem Zwischenraum entlang zu erzeugender Kanäle (13, 14) angeordnet werden.

4. Verfahren nach einem der vorangehenden Ansprüche, **dadurch gekennzeichnet, dass** während des Verbindungsvorgangs der Platten (1, 2) die Druckdifferenz zwischen dem Innenraum (4) und dem Außenraum der Platten mittels einer Druckmesseinrichtung (15) gemessen wird und/oder dass während des Verbindungsvorgangs der Platten (1, 2) mittels eines Temperatursensors (16) die Temperatur gemessen wird.

5. Einrichtung zur Herstellung einer Plattenanordnung mit zwei Platten (1, 2), die wenigstens abschnittsweise einen gleichbleibenden Abstand (d) zueinander aufweisen und/oder parallel zu einander angeordnet sind, wobei die Einrichtung eine Vakuumvorrichtung (13) zum Absaugen eines Fluids, insbesondere eines Gases, aus dem Zwischenraum (4) zwischen den Platten (1, 2) aufweist und wobei die Einrichtung eine eine Vorrichtung zur Steuerung der Temperatur der Plattenanordnung mittels einer Heizung (17) aufweist, die in Abhängigkeit vom Material der Platten derart einrichtbar ist, dass wenigstens eine der beiden Platten während der Zeit, in der der Druck im Zwischenraum geringer ist als im Außenraum, vorübergehend bis über die Erweichungstemperatur ihres Materials hinaus erhitzt wird.

6. Verfahren nach einem der Ansprüche 1 bis 4, **dadurch gekennzeichnet, dass** der Druckunterschied während des Bestehens der Druckdifferenz 10 bis 900 mbar beträgt.

7. Verfahren nach einem der Ansprüche 1 bis 4 oder 6, **dadurch gekennzeichnet, dass** der Druckunterschied für eine Dauer von mindestens einer Sekunde und/oder von höchstens 120 Sekunden, vorzugsweise von höchstens 30 Sekunden aufgebracht wird.

8. Verfahren nach einem der Ansprüche 1 bis 4, 6 oder 7, **dadurch gekennzeichnet, dass** der Abstand zwischen den Platten höchstens 100 µm, vorzugsweise auf 5 bis 100 µm, besonders bevorzugt auf 5 bis 50 µm beträgt.

## Claims

1. A method for producing a plate arrangement with two plates (1, 2) which at least in sections have an intermediate space (4) located between them and a constant distance (d) to one another and/or are arranged parallel to one another, and between which a fusible solder material (3, 3') is arranged, **characterized in that** a pressure difference is produced between the intermediate space (4) between the plates and the outer space surrounding the plates in such a way that the pressure in the outer space is higher than in the intermediate space (4) and **in that** the temperature of the solder material (3, 3') is at least temporarily raised above its melting temperature or its bonding temperature during the existence of the pressure difference, **characterized in that** at least one plate, in particular both plates (1, 2), is/are heated at least temporarily to above the softening temperature of its/their material during the time when the pressure in the outer space is higher than in the intermediate space (4).

2. The method according to claim 1, **characterized in that** particles (5, 5') are arranged between the plates (1, 2), in particular in the solder material (3, 3'), the diameter of which particles corresponds to the distance (d) to be achieved between the plates and the softening temperature of which is higher than the melting temperature of the solder material (3, 3'), the temperature remaining below the softening temperature of the particle material during the joining of the plates.

3. The method according to claim 2, **characterized in that** the particles (5, 5') are arranged in the intermediate space along channels (13, 14) to be created.

4. The method according to one of the preceding claims, **characterized in that** during the joining process of the plates (1, 2), the pressure difference between the inner space (4) and the outer space of the plates is measured by means of a pressure measuring device (15) and/or **in that** during the joining process of the plates (1, 2), the temperature is measured by means of a temperature sensor (16).

5. A sdevice for producing a plate arrangement with two plates (1, 2) which are at least in sections at a constant distance (d) from one another and/or are arranged parallel to one another, the device having a vacuum device (13) for drawing off a fluid, in particular a gas, from the intermediate space (4) between the plates (1, 2), and wherein the device comprises a device for controlling the temperature of the plate assembly by means of a heater (17) which can be configured, depending on the material of the plates, such that at least one of the two plates is heated at least temporarily to above the softening temperature of its material during the time when the pressure in the intermediate space is lower than in the outer space.

6. A method according to any one of claims 1 to 4, **characterized in that** the pressure difference during the existence of the pressure difference is 10 to 900 mbar.

7. A method according to one of claims 1 to 4 or 6, **characterized in that** the pressure difference is applied for a duration of at least one second and/or of at most 120 seconds, preferably of at most 30 seconds.

8. A method according to any one of claims 1 to 4, 6, or 7, **characterized in that** the distance between the plates is at most 100 µm, preferably 5 to 100 µm, more preferably at 5 to 50 µm.

## Revendications

1. Procédé de fabrication d'un ensemble de plaques comprenant deux plaques (1, 2) qui présentent au moins par endroits un espace intermédiaire (4) placé entre elles et un espacement (d) constant l'une par rapport à l'autre et/ou qui sont agencées de manière parallèle l'une par rapport à l'autre et entre lesquelles un matériau de brasage (3, 3') pouvant fondre est agencé, une différence de pression étant générée entre l'espace intermédiaire (4) entre les plaques et l'espace extérieur entourant les plaques, de telle manière que la pression dans l'espace extérieur est plus élevée que dans l'espace intermédiaire (4) et que la température du matériau de brasage (3, 3') est augmentée au moins temporairement au cours de la présence de la différence de pression au-dessus de sa température de fusion ou de sa température de liaison, **caractérisé en ce qu'**au moins une plaque, en particulier les deux plaques (1, 2), est chauffée au-dessus de la température de ramollissement de son matériau pendant le temps pendant lequel la pression dans l'espace extérieur est plus élevée que dans l'espace intermédiaire (4).

2. Procédé selon la revendication 1, **caractérisé en ce que** des particules (5, 5') sont agencées entre les plaques (1, 2), en particulier dans le matériau de brasage (3, 3'), dont le diamètre correspond à l'espacement (d) à atteindre entre les plaques et dont la température de ramollissement est supérieure à la température de fusion du matériau de brasage (3, 3'), la température lors de la liaison des plaques restant inférieure à la température de ramollissement du matériau des particules.

3. Procédé selon la revendication 2, **caractérisé en ce que** les particules (5, 5') sont agencées dans l'espace intermédiaire le long de canaux (13, 14) à créer.

4. Procédé selon l'une quelconque des revendications précédentes, **caractérisé en ce que** pendant le processus de liaison des plaques (1, 2), la différence de pression entre l'espace intérieur (4) et l'espace extérieur des plaques est mesurée au moyen d'un dispositif de mesure de pression (15) et/ou **en ce que** pendant le processus de liaison des plaques (1, 2), la température est mesurée au moyen d'un capteur de température (16).

5. Dispositif de fabrication d'un ensemble de plaques comprenant deux plaques (1, 2) qui présentent au moins par endroits un espacement (d) constant l'une par rapport à l'autre et/ou qui sont agencées de manière parallèle l'une par rapport à l'autre, le dispositif comprenant un dispositif à vide (13) pour aspirer un fluide, en particulier un gaz, depuis l'espace intermédiaire (4) entre les plaques (1, 2), et dans lequel le dispositif présente un moyen pour réguler la température de l'agencement de plaques au moyen d'un chauffage (17), qui peut être conçu, en fonction du matériau des plaques, de telle manière qu'au moins une des deux plaques soit temporairement chauffée au-dessus de la température de ramollissement de son matériau pendant le temps pendant lequel la pression dans l'espace intermédiaire est inférieure à l'espace extérieur.

6. Procédé selon l'une quelconque des revendications 1 à 4, **caractérisé en ce que** la différence de pression pendant la présence de la différence de pression est de 10 à 900 mbar.

7. Procédé selon l'une quelconque des revendications 1 à 4 ou 6, **caractérisé en ce que** la différence de pression est appliquée pendant une durée d'au moins une seconde et/ou d'au plus 120 secondes, de préférence d'au plus 30 secondes.

8. Procédé selon l'une quelconque des revendications 1 à 4, 6 ou 7, **caractérisé en ce que** la distance entre les plaques est d'au plus 100 µm, de préférence de 5 à 100 µm, de manière particulièrement préférée de 5 à 50 µm.
